# EUROPEAN PATENT SPECIFICATION

(11) **EP 0 786 667 B1**
(45) Date of publication and mention of the grant of the patent: **27.10.2004**
(21) Application number: 96307905.8
(22) Date of filing: 31.10.1996
(51) Int. Cl.: G01R 31/317, G06F 11/267

(54) **Method and apparatus for testing integrated circuits**
Verfahren und Vorrichtung zur Prüfung von integrierten Schaltungen
Procédé et dispositif pour tester des circuits intégrés

(30) Priority: 31.10.1995 US 8184; 31.10.1995 US 8138; 31.10.1995 US 8186; 31.10.1995 US 7102
(43) Date of publication of application: 30.07.1997
(73) Proprietor: TEXAS INSTRUMENTS INCORPORATED, Dallas Texas 75265 (US)
(72) Inventor: Whetsel, Lee D., Allen, Texas 75002 (US)
(74) Representative: Legg, Cyrus James Grahame

(56) References cited:
- US-A- 4 092 733
- US-A- 4 286 173
- US-A- 4 812 678

## Description

### FIELD OF THE INVENTION

The invention relates generally to integrated circuit manufacturing and, more particularly, to testing die on wafer.

### BACKGROUND OF THE INVENTION

Integrated circuit (ICs) manufacturers produce dies on typically circular substrates referred to as wafers. A wafer may contain hundreds of individual rectangular or square dies. Dies on wafer, or unsingulated dies must be tested to determine good from bad before the dies are singulated. Unsingulated die testing traditionally occurs by physically probing each die at the die pads, which allows a tester connected to the probe to determine good or bad dies. This type of probing is relatively slow and requires expensive mechanical mechanisms to accurately step and position the probe at each die location on the wafer. The probing step can damage the die pads which may interfere with the bonding process during IC packaging or assembly of bare dies on MCM substrates. Also, as die sizes shrink, pads are positioned closer and closer together and it becomes more difficult and costly to design precision probing instruments to access them.

Alternate conventional methods for testing unsingulated dies on wafers include: (1) designing each die to test itself using built-in-self-test (BIST) circuitry on each die and providing a way to enable each die BIST circuitry to test the die, (2) widening the scribe lanes between the dies to allow for: (a) test probe points, (b) test access conductors, and/or (c) test circuitry, and (3) processing an overlying layer of semiconductor material with test circuitry over the dies on wafers and providing via connections, from the overlying layer, to the pads of each die on the wafer. Method 1 disadvantageously requires BIST circuitry on the dies which takes up area, and the BIST circuitry may not be able to adequately test the I/0 of the dies Method 2 disadvantageously reduces the number of dies that can be produced on a wafer since the widening of the scribe lanes takes up wafer area which could be used for additional dies Method 3 disadvantageously requires additional wafer processing steps to form the overlying test connectivity layer on top of the dies on wafers, and also the overlying layer needs to be removed from the wafer after testing is complete. This overlying layer removal step is additive in the process and the underlying dies could be damaged during the removal step.

Ideally, only good dies are singulated and packaged into ICs. The cost of packaging dies is expensive and therefore the packaging of bad dies into ICs increases the manufacturing cost of the IC vendor and results in a higher cost to the consumer.

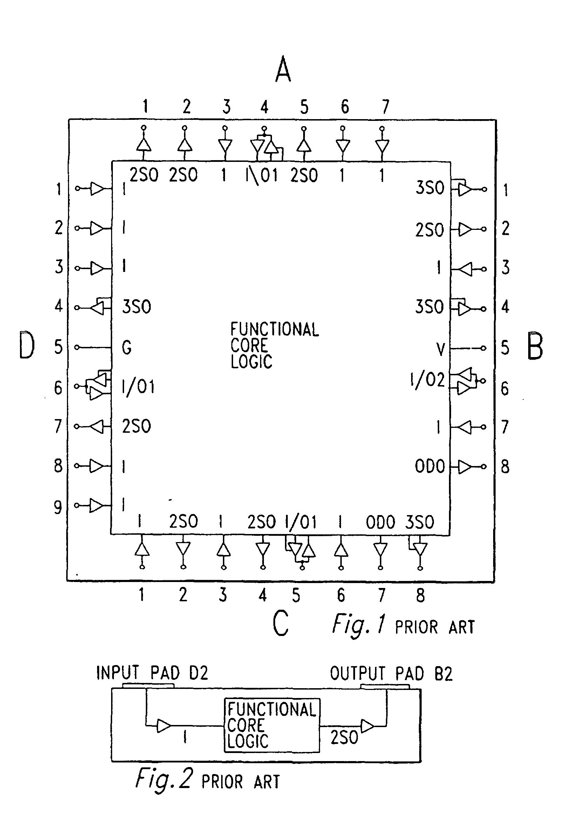

Figure 1 illustrates a schematic of a die 1 containing functional core logic (FCL) 2, and input and output buffering to pad locations. The variety of pad buffering shown includes: inputs (I), 2-state outputs (2SO), 3-state outputs (3SO) , open drain outputs (ODO), input and 3SO bidirectionals (I/O1), and input and ODO bidirectionals (I/O2). The FCL 2 could be a custom or semicustom (ASIC) implementation comprising: microprocessors, combinational logic, sequential logic, analog, mixed signal, programmable logic, RAMs, ROMs, Caches, Arrays, DSPs, or combinations of these and/or other functions. The die 1 is shown having a top side A, right side B, bottom side C, and left side D for convenience of description in regard to its position on the wafer. The die 1 also has at least one voltage supply (V) pad and at least one ground (G) pad for supplying power to the die 1. Side A has pad locations 1-7, B has pad locations 1-8, C has pad locations 1-8, and D has pad locations 1-9. The arrangement of the buffer/pad combinations on each side (A,B,C,D) corresponds to the desired pinout of the package that the die 1 will be assembled into, or to signal terminals on a multi-chip module (MCM) substrate onto which the die 1 will be connected. Figure 2 is a cutaway side view of the die showing an input pad at D2 and an output pad at B2 both connected to the FCL 2.

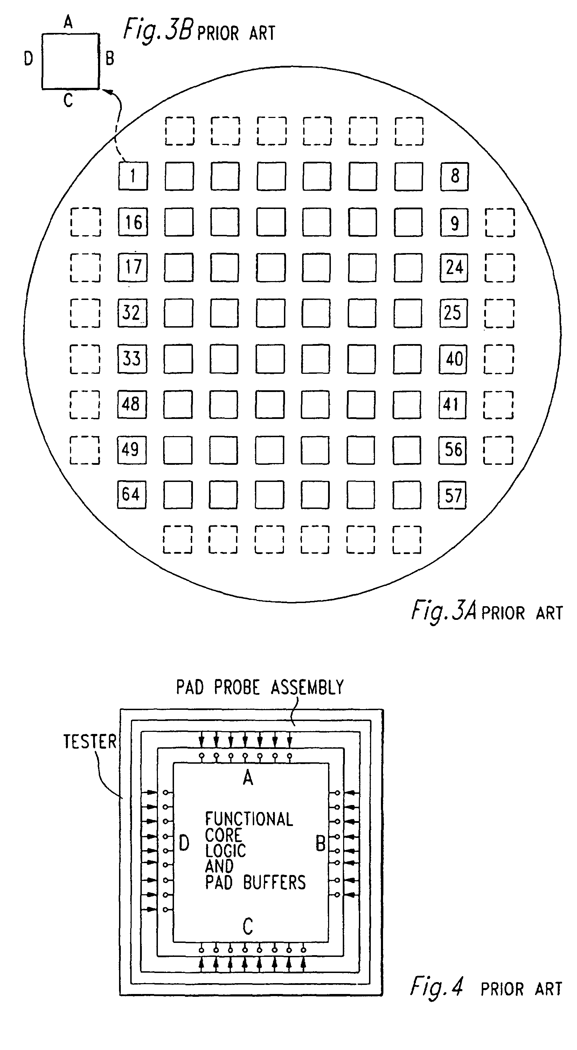

Figure 3A shows an example wafer containing 64 of the dies of Figure 1. Figure 3B shows the position of each die 1 on the wafer with respect to sides A, B, C, and D. The phantom die 1¹ in dotted line shows how the wafer would be packed to yield more die per wafer. Notice that even when the die 1 is tightly packed on the wafer (i.e. the phantom die 1¹ locations utilized), there is still area at the periphery of the wafer where dies cannot be placed. This is due to the circular shape of the wafer versus the square/rectangular shape of the dies This unusable peripheral area 3 of the wafer can be used to place test points (pads), test circuitry, and conductors for routing test signals and power and ground to dies

Figure 4 shows how conventional die testing is performed using a tester and pad probe assembly. The probe assembly is positioned over a selected die 1 and lowered to make contact with the die pads. Once contact is made the tester applies power and checks for high current. If current is high a short exists on the die and test is aborted and the die is marked (usually by an ink color) as bad. If current is normal, then testing proceeds by applying test patterns to the die and receiving test response from the die. If the test fails the die 1 is marked as bad. If the test passes the die is good and not marked, or if marked, marked with a different ink color. During testing the die current can be monitored to see if it stays within a specified range during the test. An out of range current may be marked as a high current functional failure.

Such conventional wafer testing has several disadvantages. The act of probing the die 1 scars the metal die pads. Thus, using physical probing, it is essential that dies be tested only once, since re-probing a die 1 to repeat a test may further damage the pads. Even a single probing of a die 1 may cause enough pad damage to adversely affect subsequent assembly of the die 1 in IC packages or on MCM substrates. With the extremely small target provided by a die pad, the equipment used for positioning the probe on a die pad must be designed with great care and is therefore very expensive to purchase/build and maintain and calibrate. Also the stepping of the probe to each die location on the wafer takes time due to the three dimensional motions the probe must be moved through to access and test each die 1 on the wafer.

It is therefore desirable to test die on wafers without the disadvantages described above.

US 4,092,733 discloses a wafer scale integration system. The system connects operating circuit blocks to the input and output leads. The system bypasses defective circuit blocks and substitutes operable, redundant circuits for them. Electrically alterable, non-volatile interconnect circuits, or switches, selectively connect and disconnect microcircuit blocks formed on a wafer. The interconnects are formed on the same wafer as the microcircuit elements during the circuit fabrication process to permit electrically controlled reconfiguration of the microcircuit elements on the wafer. MNOS memory transistors provide non-volatile storage of the chosen conductivity state of each interconnect.

US 4,286,173 discloses a logical circuit including a logic block for performing a logical function and a selection circuit receiving a selection signal. When the selection signal takes a selected value, the input signals to the logic block are bypassed through the bypass circuit, without being passed through the logic circuit, and delivered as the outputs of the selection circuit.

US 4,812,678 discloses, in a large scale integrated (LSI) circuit, a through-passage circuit together with a selector circuit provided between an input circuit and an output circuit. The through-passage circuit selectively short-circuits the input circuit to the output circuit. In testing a complex circuit including two or more such LSIs, the internal circuit of the LSIs can be selectively extremely simplified to enable easy and fast testing.

According to the present invention there is provided an integrated circuit, comprising:
functional circuitry for performing normal operating functions of the integrated circuit, said circuitry including first and second nodes which are electrically distinct from each other; and
first and second bond pads selectively connectable to and disconnectable from said first and second nodes, respectively, said first and second bond pads also selectively connectable to and disconnectable from each other;
a first bond pad and a first lead, the first lead connecting the first bond pad to the first node; and
a second bond pad and a second lead, the second lead connecting the second bond pad to the second node;
characterized in that the integrated circuit includes first switching circuitry for selectively disconnecting the first bond pad from the first node and second switching circuitry for selectively disconnecting the second bond pad from the second node and a selectable connection path for selectively connecting together the first bond pad and the second bond pad for passage of electrical signals from the first bond pad to the second bond pad and from the second bond pad to the first bond pad when the first and second nodes are disconnected from the first and second bond pads.

The functional circuitry may include an input buffer and an output buffer and the first node may then be the input to the input buffer and the second node may then be the output of the output buffer. The functional circuitry may include an input buffer and a state holding circuit (ISH) between the first switching circuitry and the input of the input buffer.

The functional circuitry may include two input buffers and the first node may then be an input to one input buffer and the second node may then be an input to the other input buffer. Alternatively, the functional circuitry may include two output buffers and the first node may then be an output of one output buffer and the second node may then be an output of the other output buffer.

In example embodiments of the invention a die framework is provided comprising die resident circuitry and connections to selectively provide either a bypass mode wherein the die has direct pad-to-pad connectivity or a functional mode wherein the die has die pad to functional core logic connectivity; a fault tolerant circuit is provided and a die on a wafer is selected to be placed in functional mode while other die remain in bypass mode; (1) one die on a wafer is selected electronically to be placed in functional mode for testing while other die on the wafer are in bypass mode, (2) that selected die is tested, and (3) the electronic selection and testing steps are repeated on other die; (1) a plurality of diagonally positioned die on the wafer are electronically selected to be placed in functional mode for testing while other die on the wafer are in bypass mode, (2) the selected group of diagonally positioned die are tested in parallel, and (3) the electronic selection and testing steps are repeated on other groups of diagonally positioned die.

The present invention provides improved testing of unsingulated die on wafer. The invention provides the following exemplary improvements: (1) electronic selection and testing of unsingulated dies on wafer, (2) faster testing of dies on wafer, (3) elimination of expensive, finely designed mechanical wafer probes, (4) the ability to at-speed test unsingulated dies on wafer, (5) the ability to test a plurality of unsingulated dies in parallel, and (6) the ability to simplify the burn-in testing of unsingulated dies.

### BRIEF DESCRIPTION OF THE DRAWINGS

The present invention will now be further described by way of example with reference to embodiments of the accompanying drawings:
Figure 1 diagramatically illustrates the functional core logic, input and output pads and pad buffering structures of a conventional integrated circuit die;
Figure 2 is a cutaway side view of a portion of the conventional die of Figure 1;
Figures 3A-3B illustrate the placement and orientation of a plurality of die on a conventional wafer;
Figure 4 illustrates a conventional arrangement for testing die on a wafer;
Figure 5 diagramatically illustrates the functional core logic, input and output pads and pad buffering of an exemplary integrated circuit die according to the present invention;
Figure 6 schematically illustrates pad-to-pad connections that exist in the die of Figure 5 when in a bypass mode;
Figures 7A-11B are cutaway side views of various portions of the Figure 5 die in both functional and bypass modes;
Figure 12A illustrates an exemplary embodiment of the input state holder of Figure 7A;
Figure 12B illustrates an alternative to the input state holder of Figure 12A;
Figures 13A-14B are further cutaway side views similar to Figures 7A-11B;
Figures 15A-15B illustrate an exemplary arrangement for bussing power and ground to each die on a wafer;
Figures 16A-16B illustrate an exemplary die selection scheme;
Figures 17A-17B illustrate the operation of the die selectors of Figure 16A;
Figures 18A-18C illustrate the structure and operation of the die selection scheme of Figure 16A;
Figures 19A-19C illustrate a fault tolerant feature of the die selection scheme of Figure 16A;
Figure 19D illustrates the die selection scheme of Figure 16A applied to a plurality of dies on a plurality of wafers;
Figures 20A-20B illustrate another exemplary die selection scheme;
Figures 21A-21B illustrate the operation of the die selectors of Figure 20A;
Figures 22A-23B illustrate the structure and operation of the die selection scheme of Figure 20A;
Figures 24A-24C illustrate a fault tolerant feature of the die selection scheme of Figure 20A;
Figures 24D and 24E diagramatically illustrate an exemplary implementation of the die selector defined in Figures 21A-23B;
Figures 24F and 24G diagrammatically illustrate an exemplary implementation of the die selector defined in Figures 17A-18C;
Figures 25A-25E illustrate an exemplary arrangement for testing dies on wafer;
Figure 26 illustrates a portion of Figure 25A in greater detail;
Figure 27 illustrates an exemplary arrangement for testing a plurality of dies on wafer in parallel;
Figure 28 illustrates an exemplary power and ground bussing arrangement for use with the testing arrangement of Figure 27;
Figure 29 illustrates an exemplary die selection scheme for use with the testing arrangement of Figure 27;
Figure 30 illustrates a portion of Figure 27 in greater detail;
Figures 31A-31O illustrate a sequence of testing steps supported by the arrangement of Figure 27, wherein groups of diagonally positioned die are tested in parallel fashion.

### DETAILED DESCRIPTION

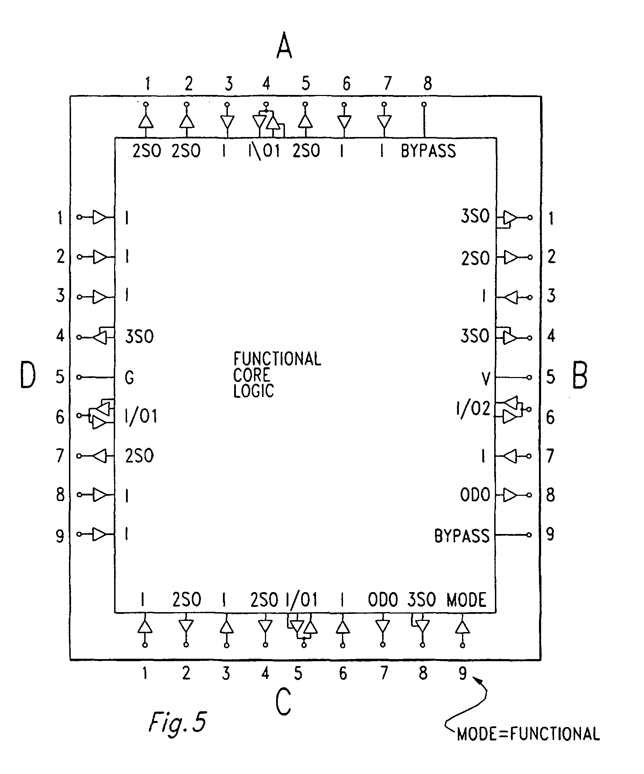

In Figure 5 a die 1 schematic similar to that of Figure 1 is shown. Like Figure 1, the die has sides A, B, C, and D and corresponding pad sites for input, output, input/output, V and G. Figure 5 includes additional pad sites A8 and B9 referred to as bypass, and an additional pad site C9 referred to as mode. The mode pad is buffered like a data input. When mode is at a predetermined logic level, say high, the die schematic appears as shown in Figure 5, and the die is in its functional mode which is exactly the equivalent of the die in Figure 1. In functional mode, the FCL 2, input, output, and input/output pads are enabled and the die performs its intended function. In functional mode, the bypass pads are not used.

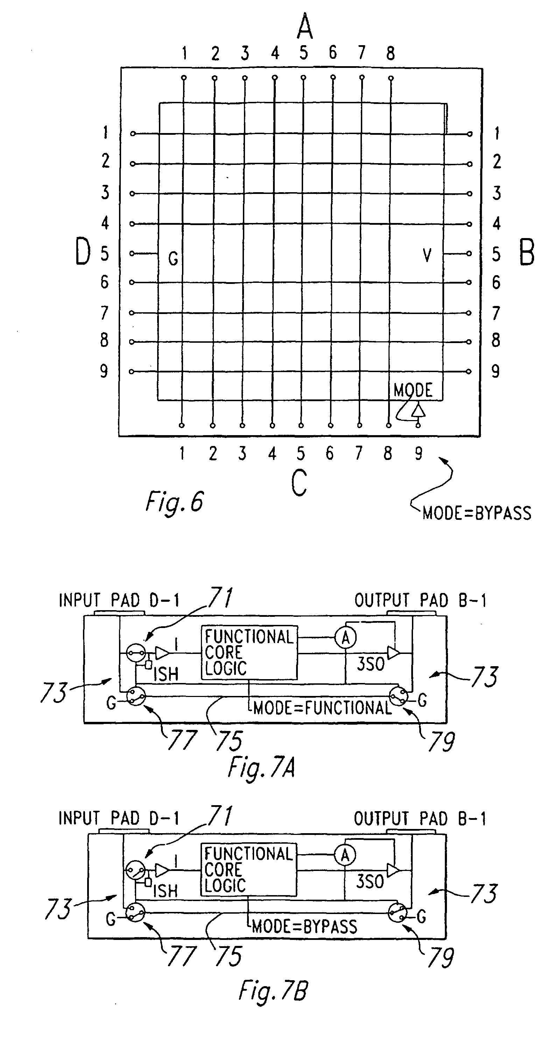

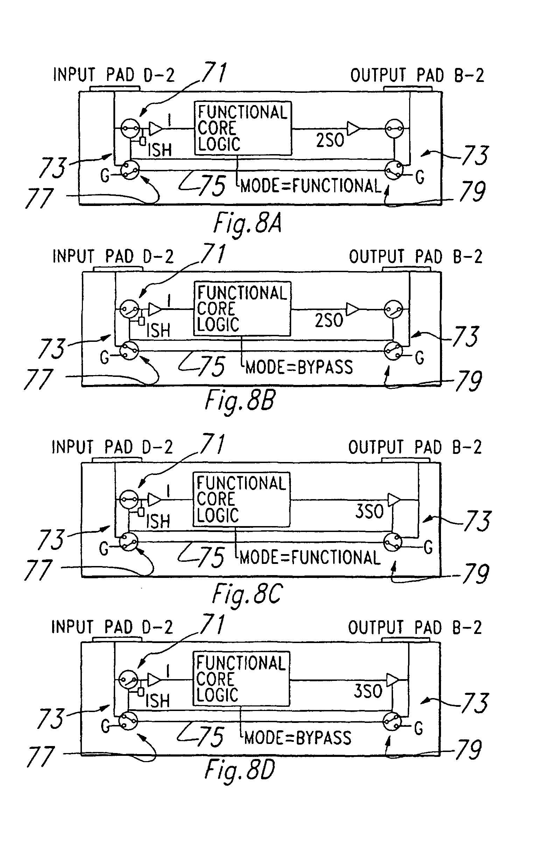

In exemplary Figure 6, the die 1 of Figure 5 is schematically shown as it would operate in the bypass mode of the present invention. The die is placed in bypass mode by taking the mode pad to a logic state opposite that of the functional mode logic state, in this case a logic low. In bypass mode, the die's FCL 2, input, output, and input/output buffers are disabled and pad sites of corresponding position between sides A and C and between sides D and B are electrically connected. In bypass mode the die 1 is transformed into a simple interconnect structure between sides A and C and between sides D and B. The interconnect structure includes a plurality of conductors extending parallel to one another between sides A and C, and a further plurality of conductors extending parallel to one another between sides D and B. While in bypass mode, signals from a tester apparatus can flow through the interconnects between A and C and between D and B to access and test a selected die 1 on a wafer.

While most bypass connections can be made between existing functionally required pad sites, the number of functional pad sites on one side may not equal the number of functional pad sites on the opposite side. Thus the bypass pads of Figure 5 provide pad-to-pad connectivity when the number of pads on opposite sides are not equal. For example, in Figures 5 and 6, bypass pads A8 and B9 provide connecting pads for functional pads C8 and D9 respectively. The bypass connections between opposite side die pads form a low impedance, bidirectional signaling path through the die from pad to pad. The bypass connections between two sides are preferably designed to have an equal propagation delay between opposite side pads to avoid skewing of test signals passed through bypassed die.

Assuming for example the die positioning shown on the wafer of Figure 3A, the sides of a die selected for testing need to be driven by signals from the adjacent sides of top, right, bottom, and left neighboring die which are in bypass mode (Figure 6). In order for the neighboring die to be tested, it is placed in functional mode, and: (1) all signals required at its A side are provided at the C side of the top neighboring bypassed die, (2) all signals required at its B side are provided at the D side of the right neighboring bypassed die, (3) all signals required at its C side are provided at the A side of the bottom neighboring bypassed die, and (4) all signals required at its D side are provided at the B side of the left neighboring bypassed die.

Figures 7 through 14 depict cross section views of example circuitry and connections which can achieve the framework for selective die functional and bypass modes.

Exemplary Figures 7A and 7B illustrate side views of the D1 input pad and the B1 3-state output pad of the die 1 in Figures 5 and 6. A switch 71 is provided between the input pad and input buffer to allow isolating the input pad from the input buffer during bypass mode, and an input state holder (ISH) circuit is provided between the switch and input buffer to allow holding a predetermined input state to the input buffer (which drives the FCL 2) while the switch is open during bypass mode. Gating circuitry, such as an AND gate (A), is provided in the control path between the FCL 2 and 3-state output buffer to allow the 3-state output buffer to be disabled during bypass mode. A selectable connection path 73 between the input and output pad includes a conductor 75 connected between a switch 77 associated with the input pad and a switch 79 associated with the output pad, which switches are operable to connect conductor 75 to G or to the input and output pads. The mode pad is connected to the switches, ISH and gate A as shown such that when the mode pad is in one logic state the die 1 is in functional mode and when in the opposite logic state the die is in bypass mode. The mode pad can be connected to FCL 2 as shown to permit disabling of clocks or other operations in FCL during bypass mode.

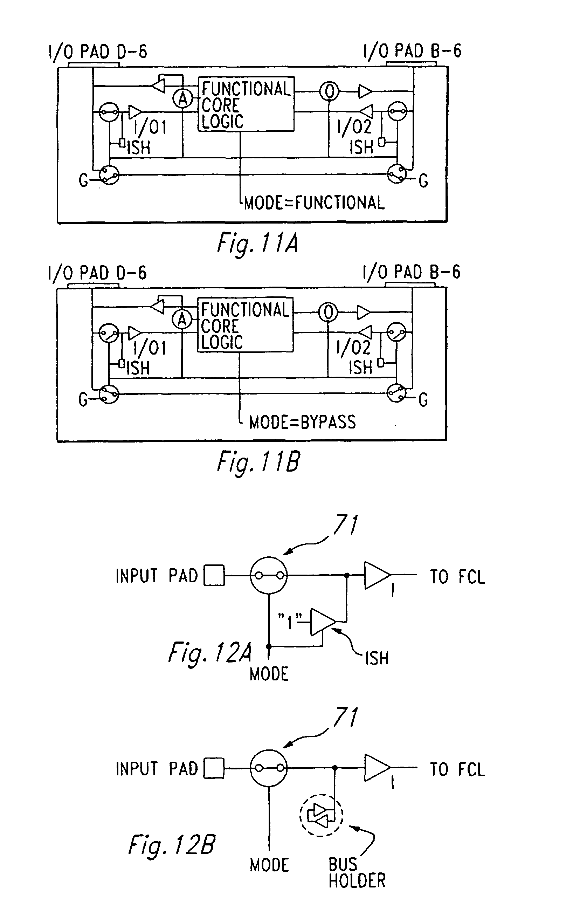

As shown in exemplary Figure 12A, ISH can be realized with a 3-state data buffer having a data input connected to a desired logic level (logic "1" in this example) and a data output connected to the input of the input buffer and a 3-state control input connected to the mode pad. The desired logic level for a given FCL input could be, for example, a logic level which minimizes current flow in the FCL 2 during bypass mode. The 3-state buffer is enabled during bypass mode and 3-stated during functional mode. If the desired logic level is a don't care condition, then the bus holder BH of exemplary Figure 12B can be used to hold the last input logic level during bypass mode.

When in functional mode (Figure7A), the switches 77 and 79 connect the conductor 75 to G which provides a ground plane on the conductor and prevents AC coupling between the input and output pads. When in bypass mode (Figure 7B), the switches 77 and 79 and the conductor 75 provide a low impedance, bidirectional signaling path connection between the input and output pads. In bypass mode, switch 71 is open to isolate FCL 2 from the input pad, and the 3-state output buffer is disabled (3-stated) via AND gate A to isolate FCL 2 from the output pad.

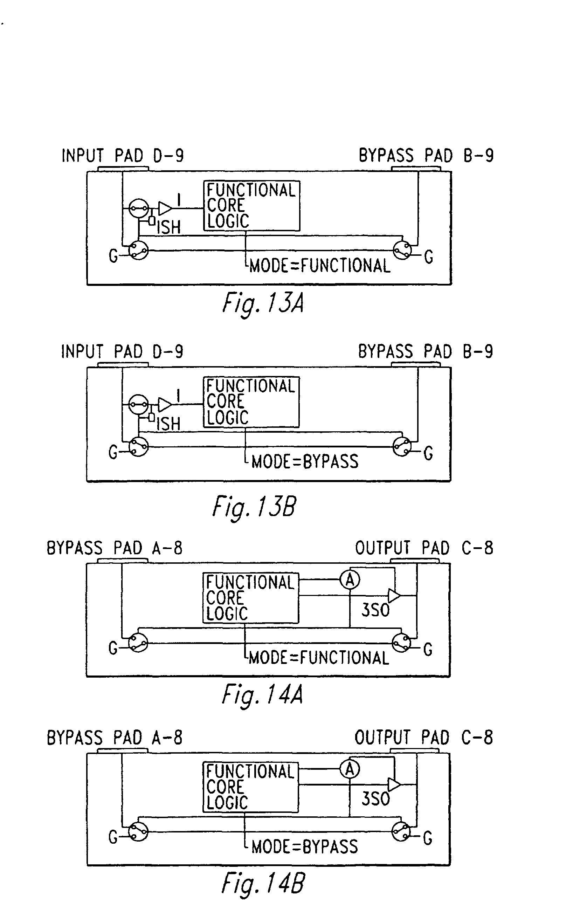

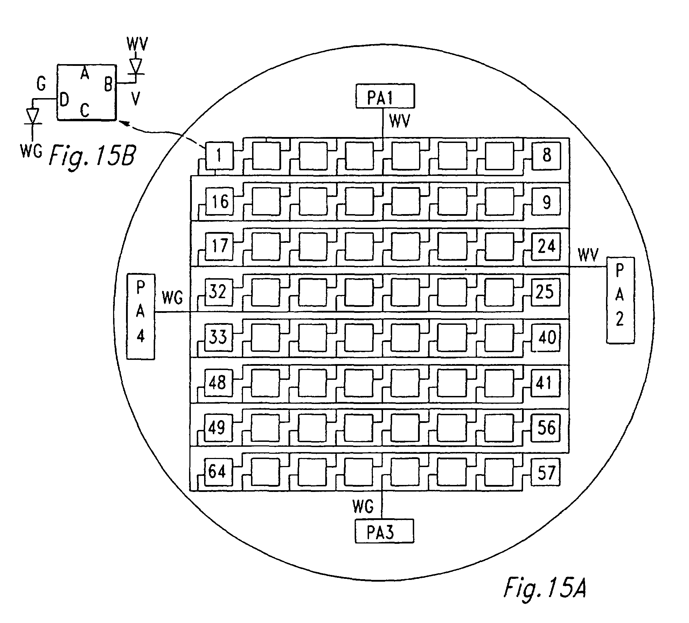

The examples of Figures 8-11 show the use of the bypass circuitry with other types of pad buffers. Figures 13 and 14 show the use of the bypass circuitry between functional input (D9) and bypass (B9) pads, and functional output (C8) and bypass (A8) pads.

In Figures 8A and 8B, a further switch 81 is used to isolate the 2-state output buffer from output pad B2 during bypass mode. Figures 8C and 8D are similar to Figures 8A and 8B except a 3-state output buffer is used instead of a 2-state output buffer and switch 81, in order to eliminate the impedance of switch 81 during functional mode.

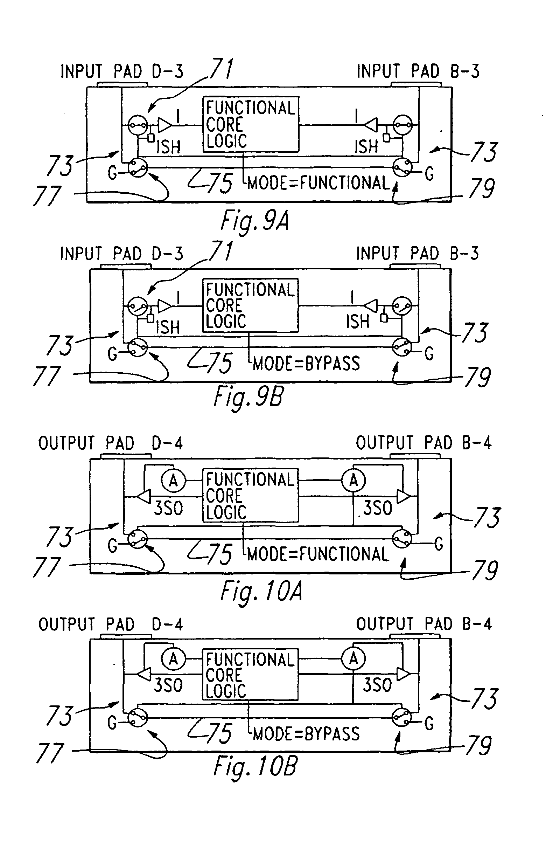

The input pads in Figures 9A and 9B and the 3-state output pads in Figures 10A and 10B are arranged in the manner described above with respect to Figures 7A and 7B.

Figures 11A and 11B illustrate I/O pads with 3-state (I/O1) and open drain (I/O2) outputs. The input buffers and the 3-state output buffer of Figures 11A and 11B are arranged as described above with respect to Figures 7A and 7B. The open drain output buffer of Figures 11A and 11B has its input connected to an output of an OR gate (O) which has one input driven by FCL 2 and another input driven by the logical inverse of the mode signal, whereby the open drain output will float high during bypass mode assuming that the mode signal selects bypass mode when low.

The input pad in Figures 13A and 13B, and the 3-state output pad in Figures 14A and 14B are arranged in the manner described above with respect to Figures 7A and 7B.

Figure 15A illustrates an example of how wafer voltage (WV) and wafer ground (WG) bussing can be distributed to the V and G pads of each die 1 on the wafer. The WV bussing is shown originating from areas of the wafer designated as probe area PA1 and probe area PA2. The WG bussing is shown originating from probe area PA3 and probe area PA4. Probe areas PA1-4 are positioned at the periphery of the wafer and in areas where die 1 cannot be placed, as mentioned in regard to Figure 3A. Figure 15B illustrates how WV and WG are coupled to the V and G die pads (see Figures 1 and 5) through diodes. By placing diodes between WG and G and WV and V, conventional localized probing and power up of an individual die 1 can occur without powering up neighboring dies.

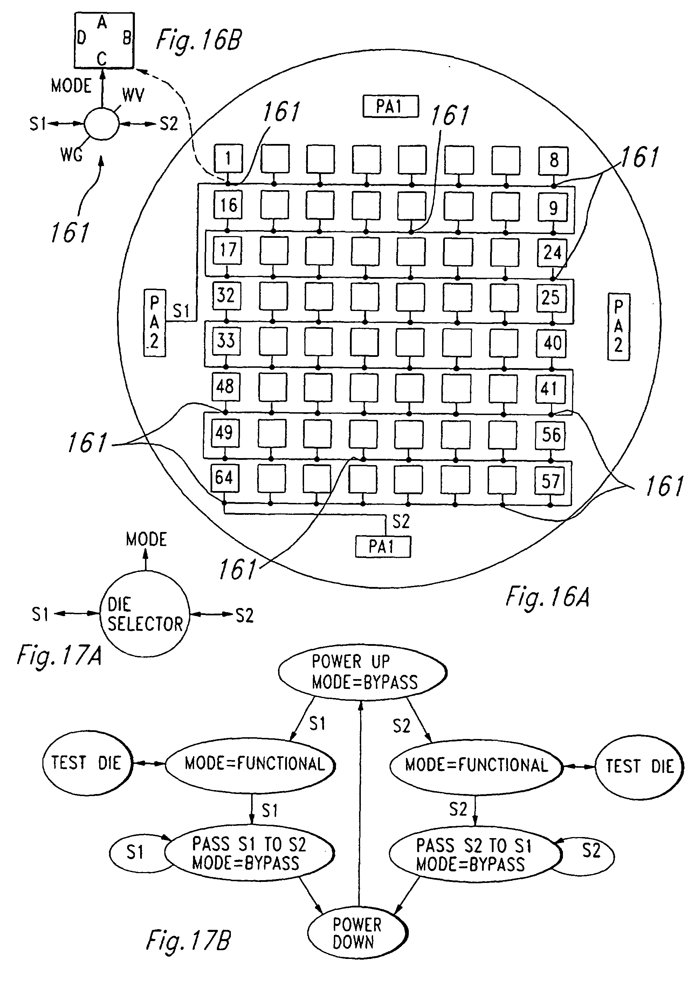

Figure 16A illustrates an exemplary scheme for performing fault tolerant selection of unsingulated die 1 on a wafer. The scheme involves the placement of a small circuit, referred to as a die selector 161, in the scribe lane adjacent each die on the wafer. The die selector 161 shown in Figure 16B includes an I/O terminal S1, an I/O terminal S2, a mode output terminal, and connections to WV and WG for power. The die selector's mode output is connected to the mode pad of an associated die. The die selectors are connected in series via their S1 and S2 terminals. In the example of Figure 16A, S1 of the first die selector in the series (at die 1) is connected to PA4, and S2 of the last die selector in the series (at die 64) is connected to PA3. Because the die selector is placed in the scribe lane instead of on the die 1, the mode pad of the die can be physically probed if required, to override the die selector mode output. This feature permits any die 1 to be tested using the conventional probe testing technique. Because the mode output of the die selector drives only the mode pad of a single die, it can be designed with a relatively weak output drive so that the conventional probe tester can easily override the mode output without any damage to the mode output.

Power is applied to WV and WG by probing PA1-PA4. When power is first applied, all the die selectors get reset to a state that forces their mode outputs low, which causes all die to be placed in bypass mode. If excess current is detected at power up (indicating perhaps a short between WV and WG), the wafer can be powered down and tested using the traditional mechanical probing technique (note that the diodes of Figure 15B allow for this). If normal current is detected (meaning that all die have successfully powered up in bypass mode) further testing.

Before testing die, the integrity of the serially connected die selectors 161 can be tested. Testing of the die selectors can occur by injecting clock pulses from PA4 to S1 of the upper left die selector (adjacent die 1) and monitoring S2 of the lower left die selector (adjacent die 64) at PA3. If the serial path between the die selectors is intact, a clock pulse output will occur on lower left S2 after 65 clock pulses have been applied to upper left S1. On the falling edge of the first injected clock pulse, die 1 is switched from bypass mode to functional mode by the mode output of the associated die selector going high. All other die are forced to remain in bypass mode by their die selectors' mode outputs being low. Also on the falling edge of the first injected clock pulse, the upper left die selector connects its S1 and S2 terminals so that subsequent S1 clocks are output on S2. On the rising edge of the second injected clock pulse, die 1 is placed back into bypass mode by its die selector's mode output going low. This second clock pulse is transferred through the upper left die selector to the next die selector via the S1 to S2 connection. On the falling edge of the second clock pulse, the die 2 selector connects its S1 and S2 terminals and switches die 2 from bypass to functional mode by driving the mode output high. This process continues on to die 64 and its die selector. On the rising edge of the 65th injected clock pulse, die 64 is placed back into the bypass mode by its die selector's mode output going low, and the 65th clock pulse is output from S2 to PA3.

Also, during the die selector test the current flow to and/or from the wafer via WV and WG can be monitored during each rising and falling clock edge to see if the expected current increase and decrease occurs as each die 1 transfers in sequence between bypass and functional modes. By sensing the wafer current fluctuations, it is possible to detect when a die that should be selected (i.e. in functional mode) is not selected, which could indicate a defect in the die selector arrangement as discussed further below.

The above description illustrates how to test and operate the die selector path from PA4 to PA3. The same test and operation mode is possible by clocking S2 of the lower left die selector from PA3 and monitoring S1 of the upper left die selector at PA4. The die selector model of exemplary Figure 17A and state diagram of exemplary Figure 17B illustrate die selector operation modes in detail. From Figure 17B it is seen that the die selector responds to a first received S1 or S2 clock pulse to output mode control (on the falling edge) to place the connected die in functional mode so that it can be tested.

After the die is tested, a rising edge on the same signal (say S1) causes the tested die to be placed back into bypass mode and also drives the S1 input of the next die selector. On the next successive falling edge the die associated with the next die selector is switched into functional mode for testing. And so on.

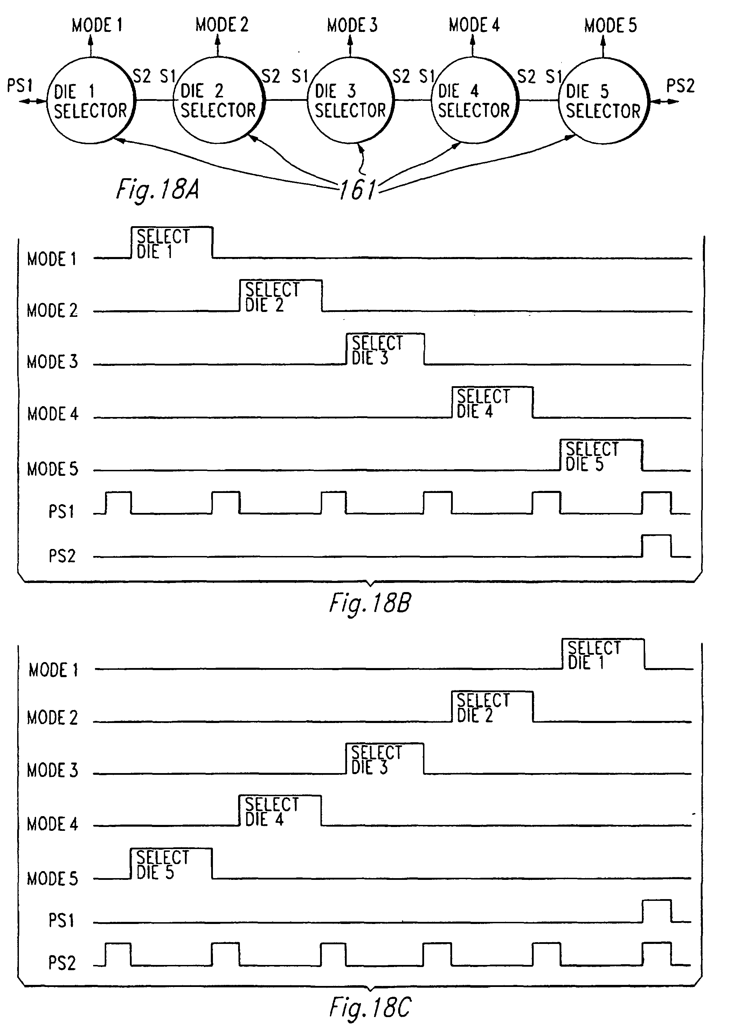

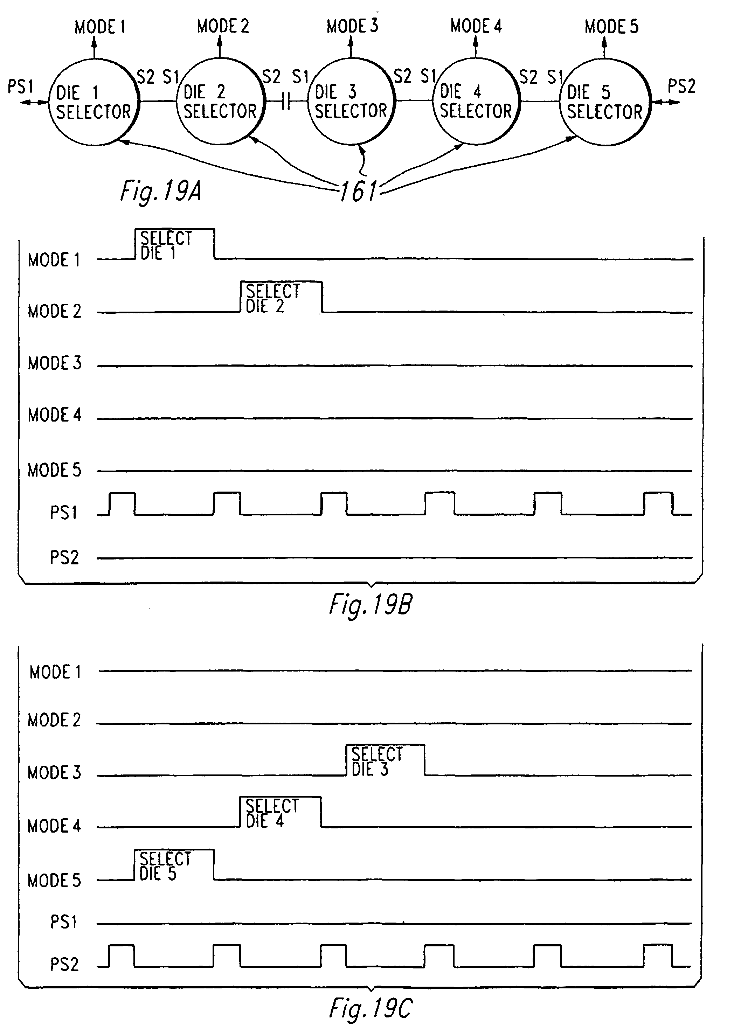

Exemplary Figures 18A-18C illustrate in detail the die selector operation described above. PS1 and PS2 in Figure 18 are externally accessible terminals (like PA3 and PA4) for injecting and receiving clock pulses. Note that the die selectors operate bidirectionally as mentioned above. The reason for the bidirectional operation is for fault tolerance, (i.e. a broken connection between two die selectors can be tolerated). An example of the fault tolerant operation of the die selector is shown in Figures 19A-19C. In Figure 19A an open circuit fault exists between the 2nd and 3rd die selectors. PS1 clock activations can only select die 1 and 2 (Figure 19B). However, PS2 clock activations can select die 5, 4, and 3 (Figure 19C). Thus even with an open circuit the die selector arrangement is able to select and place a given die in functional mode for testing.

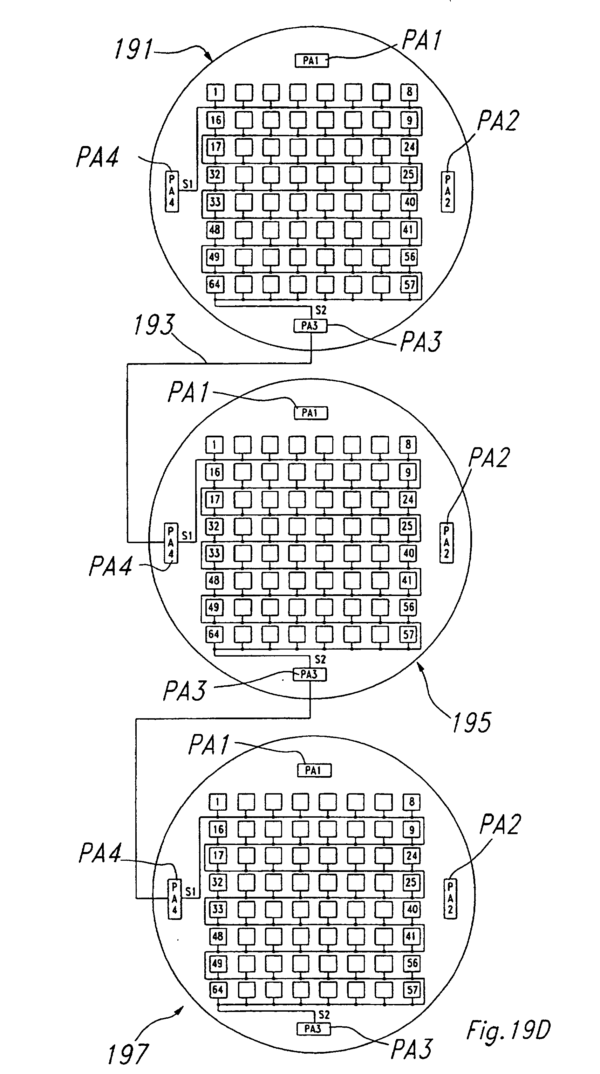

Wafers such as shown in Figure 16A may also be connected in series via the S1/S2 signals to allow selection of die on many wafers as shown in Figure 19D. S2 of the lower left die of wafer 191 is connected, via PA3 of wafer 191 and external conductor 193 and PA4 of wafer 195, to S1 of the upper left die of wafer 195. An analogous connection also exists between wafers 195 and 197. External probe connections at PA4 of wafer 191 and PA3 of wafer 197 permit the die selection scheme described above with respect to Figures 16A-18C to be applied to die on plural wafers.

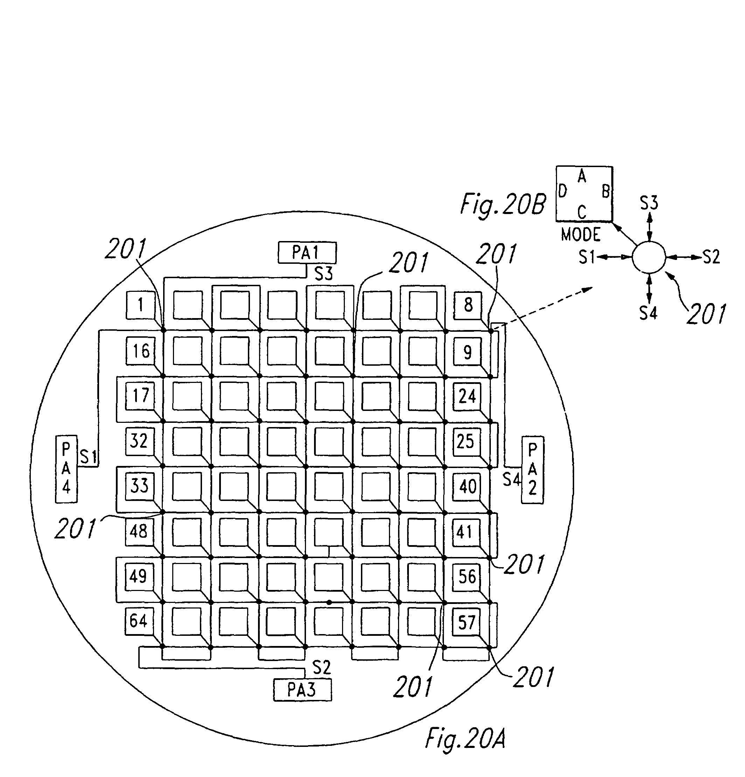

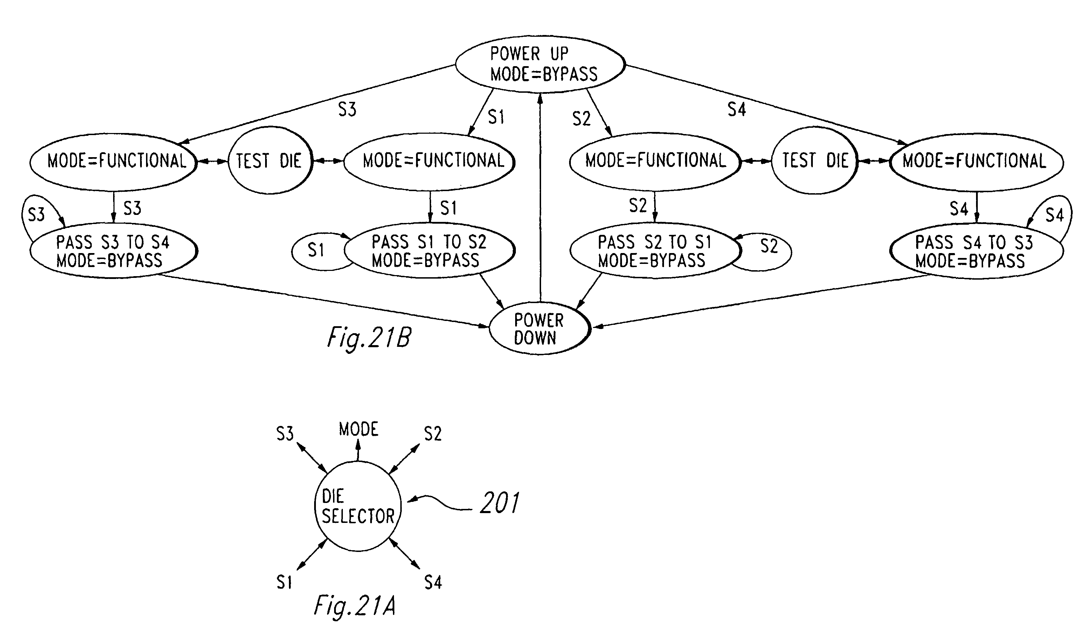

Exemplary Figures 20 and 21 illustrate how to further improve die selector fault tolerance by the addition of a second pair of I/O terminals S3 and S4 in die selector 201. In Figure 20A, the S3 and S4 serial connection path is shown routed between PA1 and PA2 in the vertical scribe lanes. Separating the S1/S2 (horizontal scribe lanes) and S3/S4 (vertical scribe lanes) routing is not required, and both routings could be in the same horizontal or vertical lanes if desired. It is clear in the example of Figure 20A that routing S1 and S2 in the horizontal lanes and routing S3 and S4 in the vertical lanes will result in different die selection orders, i.e. S1 and S2 select die order 1, 2, 3 ... 64 or die order 64, 63, 62 ... 1, whereas S3 and S4 select die order 1, 16, 17, ... 64 ... 8 or die order 8, 9, 24 ... 1.

Exemplary Figures 21A and 21B illustrate the model and state diagram of the improved fault tolerant die selector 201 of Figures 20A and 20B. The operation of the die selector 201 of Figure 21A is similar to that of the die selector 161 of Figure 17A except that the die selector 201 has redundant bidirectional selection paths. Redundant selection paths allow the die selector 201 to maintain operation even when one of its selection paths is rendered inoperable by gross defects that defeat the fault tolerance features provided in the single path die selector 161 of Figure 17A.

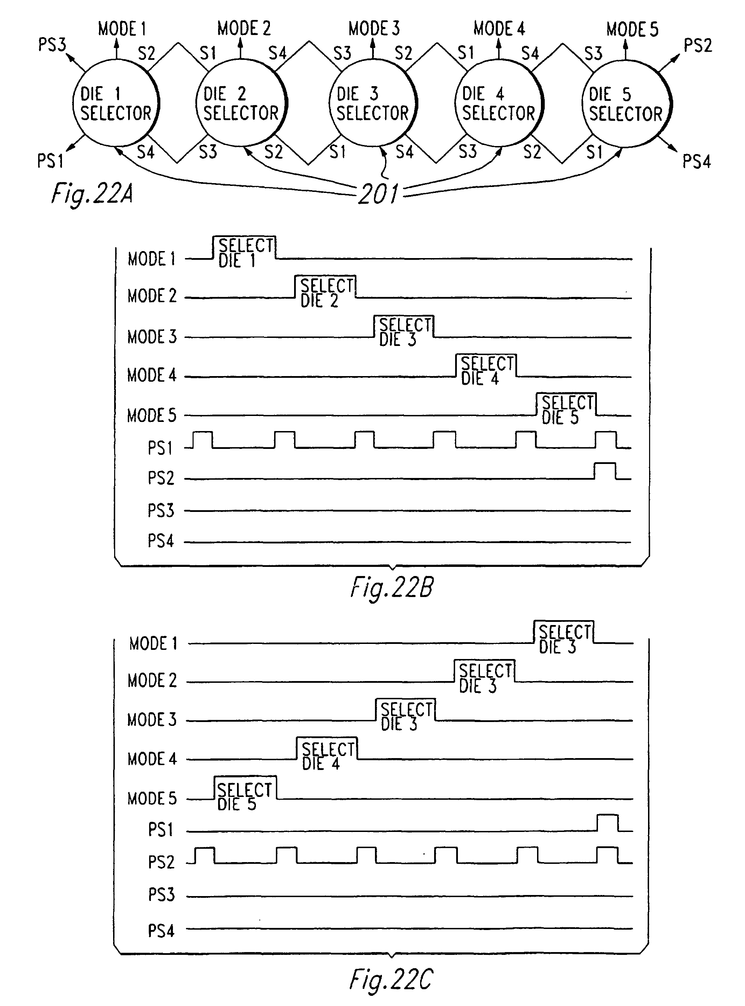

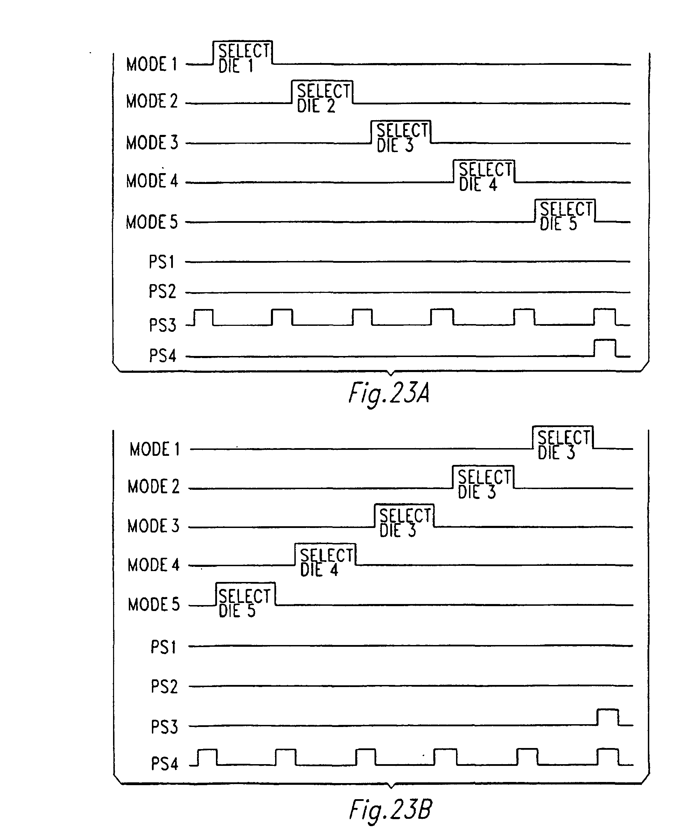

In Figures 22A-24C operational examples using dual selection path die selectors 201 are shown. For clarity, the examples show both paths (S1 and S2, and S3 and S4) routed together (in same scribe lanes) to the same sequence of die 1 through 5. This differs from the example routing of Figure 20A where S1 and S2 are routed in horizontal lanes and S3 and S4 are routed in vertical lanes, and thus each path has a different sequence of die selection. Figure 22B shows PS1 selecting die in the order 1, 2, 3, 4 & 5. Figure 22C shows PS2 selecting die in the order 5, 4, 3, 2 & 1. Figure 23A shows PS3 of Figure 22A redundantly selecting die in the same order as PS1 (Figure 22B). Figure 23B shows PS4 of Figure 22A redundantly selecting die in the same order as PS2 (Figure 22C). Both paths can tolerate a single defect (open circuit) as shown in Figures 19A-19C.

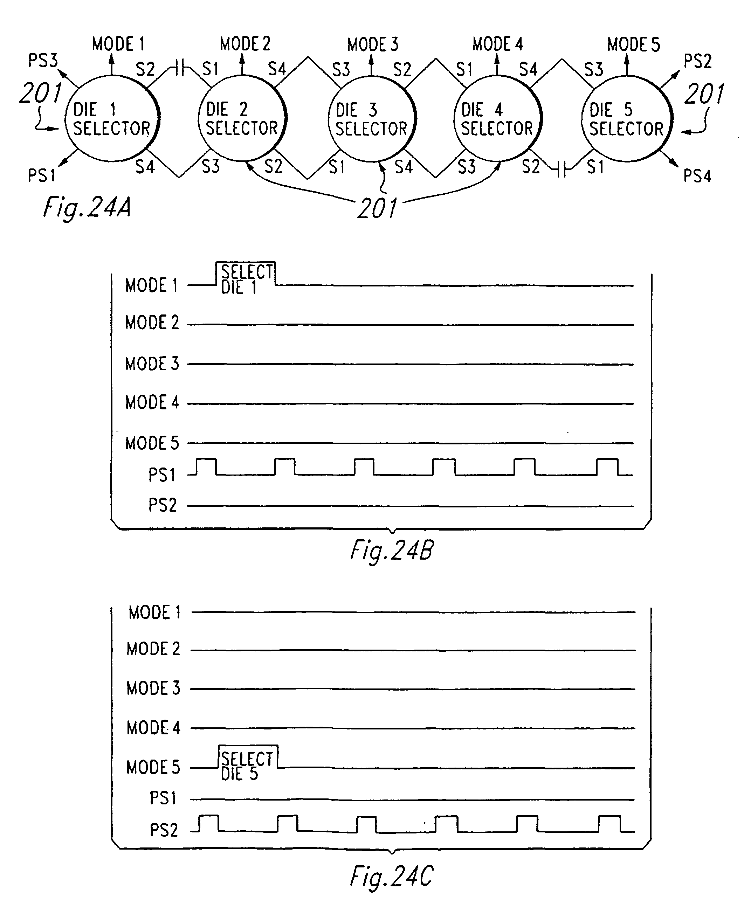

However, Figure 24A shows a multiple defect example (two open circuits) on the S1 and S2 path that would disable access to intermediate die 2, 3 & 4 if only the S1 and S2 path were provided. Figures 24B-24C illustrate that PS1 can only select die 1, and PS2 can only select die 5 with the defects shown in Figure 24A. However, since redundant selection paths are provided in the die selectors 201 of Figure 24A, the S3 and S4 path can be used to select die 2, 3 & 4 as illustrated in Figures 23A-23B. Thus an advantage of die selector 201 is that it can maintain access to die even if one of the paths is critically disabled by multiple defects.

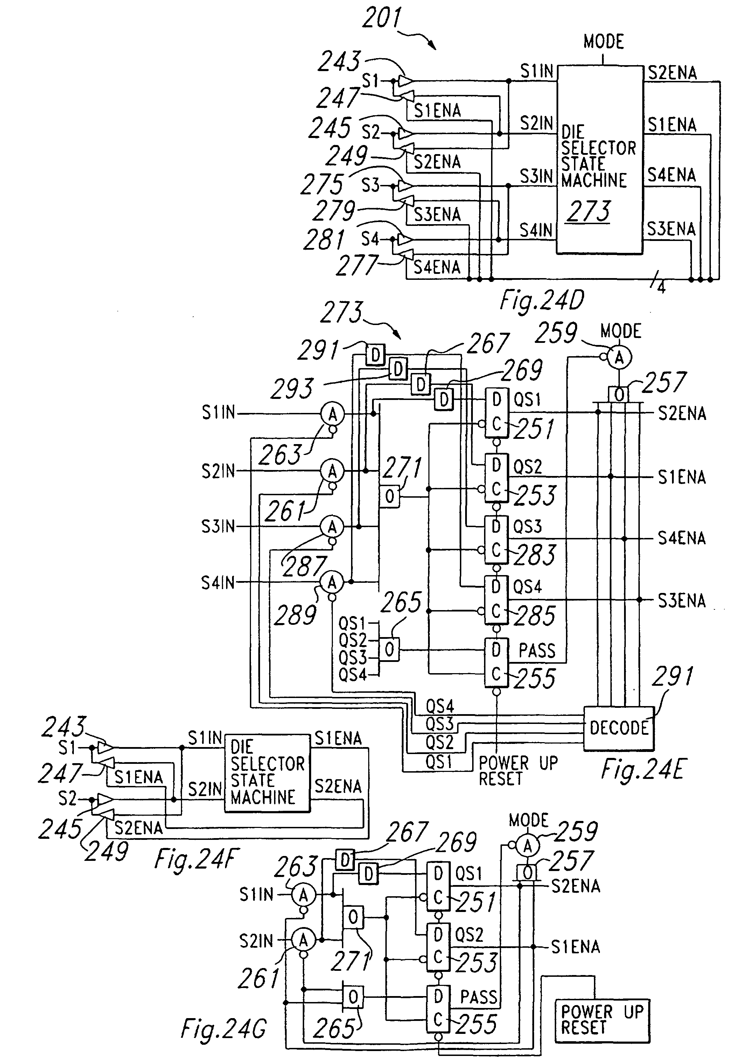

Figures 24F and 24G illustrate an exemplary implementation of the die selector 161 defined in Figures 17A-18C. In Figure 24F, input terminals S1 and S2 are respectively connected to inputs S1IN and S2IN of a die selector state machine 241 via respective input data buffers 243 and 245. The die selector state machine 241 outputs the mode signal and enable signals S1ENA and S2ENA. Enable signals S1ENA and S2ENA respectively control output data buffers 247 and 249. The output of input data buffer 243 is connected to the input of output data buffer 249 to permit signals received at terminal S1 to be output on terminal S2 when enable signal S2ENA enables output data buffer 249. Similarly, the output of input data buffer 245 is connected to the input of output data buffer 247 to permit signals received at terminal S2 to be output on terminal S1 when enable signal S1ENA enables output data buffer.247.

Exemplary Figure 24G illustrates the die selector state machine 241 of Figure 24F in greater detail. A conventional power-up reset circuit initially clears D flip-flops 251, 253 and 255 when the die selector is initially powered up. The pass signal output from flip-flop 255 is inverted at one input of AND gate 259. The other input of AND gate 259, which is driven by the output of OR gate 257, is thus qualified at gate 259 by the pass signal upon initial power up. Because flip-flop outputs QS1 and QS2 are low after initial power-up, the mode signal is therefore low after power-up. Noting that QS1 is connected to S2ENA and QS2 is connected to S1ENA, it is seen from Figure 24F that output data buffers 247 and 249 are initially disabled after power-up. Because signal QS1 is initially low, signal S2IN is initially qualified at AND gate 261, and because signal QS2 is initially low, signal S1IN is also initially qualified at AND gate 263. The low levels of QS1 and QS2 also drive the D input of flip-flop 255 low via OR gate 265. The outputs of AND gates 261 and 263 are connected to respective inputs of OR gate 271 whose output drives the clock inputs of flip-flops 251, 253 and 255. The output of AND gate 261 is connected to the D input of flip-flop 253 via delay element 267, and the output of AND gate 263 is connected to the D input of flip-flop 251 via delay element 269. Delay elements 267 and 269 are designed to have a propagation delay which is greater than the propagation delay of OR gate 271.

A rising edge of a first clock pulse on S1IN causes a logic zero to be clocked through flip-flop 255, thereby maintaining the pass signal at its initial low state. When the falling edge of the clock pulse occurs and propagates through OR gate 271 to clock flip-flop 251, the D input of flip-flop 251 will still be high due to the delay element 269, thus causing flip-flop output QS1 to go high. With QS1 high, the mode signal is driven high via OR gate 257 and AND gate 259. Also with QS1 high, the output data buffer 249 of Figure 24F is enabled via signal S2ENA, the input S2IN is disqualified at AND gate 261, and the D input of flip-flop 255 is driven high via OR gate 265. Thus, the rising edge of the second clock pulse on terminal S1 of Figure 24F passes directly to terminal S2 via output data buffer 249, and also passes through AND gate 263 and OR gate 271 of Figure 24G to clock flip-flop 255 and take the pass output thereof high, thereby driving the mode signal low. The next falling edge on terminal S1 will pass through data output buffer 249 to terminal S2, and will maintain the QS1 output of flip-flop 251 in the high logic state. The positive edge of the third clock pulse received on terminal S1 will pass through data output buffer 249 to terminal S2, and will also clock a logic one through flip-flop 255 so that the pass signal will maintain the mode output low via AND gate 259. The negative edge of the third clock pulse will maintain the logic one at the QS1 output of flip-flop 255. Each successive clock pulse after the third clock pulse on terminal S1 will achieve the same results as described with respect to the third clock pulse.

The bidirectional feature of die selector 161 should be apparent from Figures 24F and 24G. That is, if a succession of clock pulses had occurred on terminal S2 rather than on terminal S1, then output QS2 of flip-flop 253 would have been driven high to enable data output buffer 247 and disable the S1IN signal via AND gate 263. The mode signal behaves exactly the same in response to a succession of clock pulses on terminal S2 as described above with respect to the succession of clock pulses on terminal S1, and the terminal S1 will receive the second and all successive clock pulses input on terminal S2.

Exemplary Figures 24D and 24E show an implementation of die selector 201 which is similar to the implementation of die selector 161 illustrated in Figures 24F and 24G. Referencing Figure 24D, the output of data input buffer 243 is connected to the input of data output buffer 249 as in Figure 24F, and the output of data input buffer 245 is connected to the input of data output buffer 247 as in Figure 24F. Similarly, the output of data input buffer 275 is connected to the input of data output buffer 277, and the output of data input buffer 281 is connected to the input of data output buffer 279.

The die selector state machine 273 of Figure 24D is shown in greater detail in Figure 24E. As seen from Figure 24E, the die selector state machine 273 of Figure 24D represents an extension of the die selector state machine of 241 of Figure 24G. An additional AND gate 287, delay element 293, and flip-flop 283 have been added for terminal S3, and an additional AND gate 289, delay element 291 and flip-flop 285 have been added for terminal S4. The operation of these additional elements is identical to the operation described above with respect to the corresponding elements in Figure 24G. Similarly to the operation described above with reference to Figure 24G, a first falling clock pulse edge on terminal S3 will result in the QS3 output of flip-flop 283 going high to drive the mode signal high and to enable the data output buffer 277 to connect terminal S3 to terminal S4. The rising edge of the second clock pulse on terminal S3 will clock a logic one through flip-flop 255 so that the pass signal will drive the mode signal low again via AND gate 259. Similarly, the falling edge of a first clock pulse on terminal S4 will drive high the QS4 output of flip-flop 285, which drives the mode signal high and enables data output buffer 279 to connect terminal S4 to terminal S3. The decoder circuit 291 receives QS1-QS4 as inputs and provides DS1-DS4 as outputs. When QS1 is active high, the decoder circuit 291 drives DS2-DS4 active high, which disables signals S2IN, S3IN and S4IN at AND gates 261, 287 and 289. Similarly, when signal QS2 is active high, the decoder circuit drives signals DS1, DS3 and DS4 active high, when signal QS3 is active high, the decoder circuit drives signals DS1, DS2 and DS4 active high, and when QS4 is active high, the decoder circuit drives signals DS1-DS3 active high.

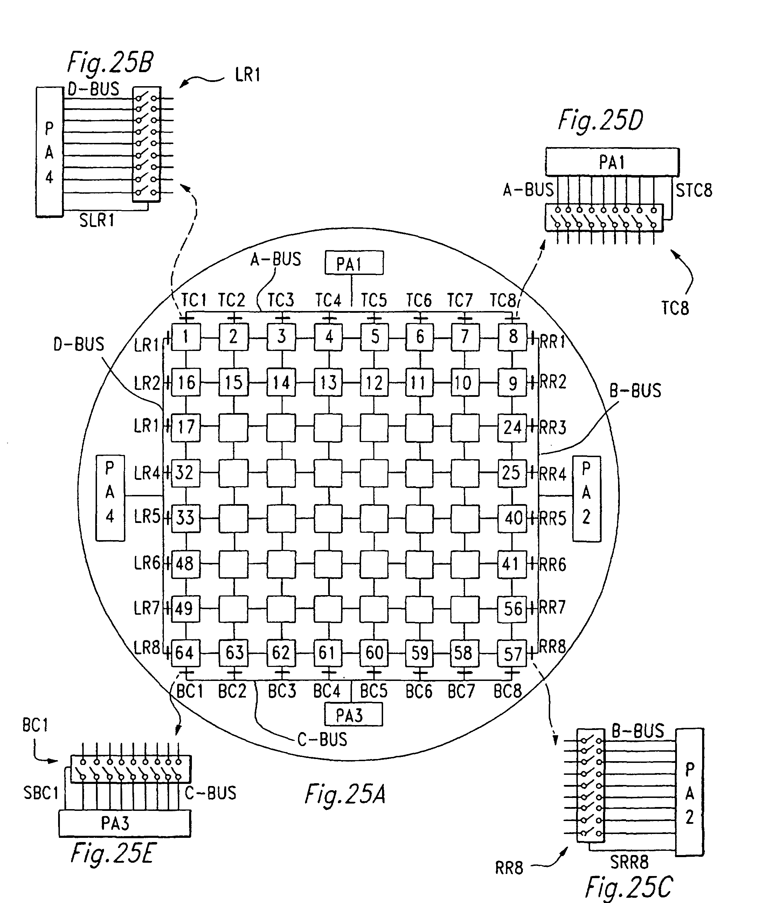

Referencing exemplary Figures 25A and 25D, probe test pads in PA1 are bussed (via A-Bus) to one side of eight top column switch groups (TC1-8), representative switch group TC8 being shown in Figure 25D. Each top column switch group also receives a select top column signal (such as STC8) from PA1 that opens or closes the switches. The other side of each top column switch group is bussed to the A side (recall Figure 5) pads of die 1, 2, 3, 4, 5, 6, 7, and 8.

Also referencing Figure 25C, probe test pads in PA2 are bussed (via B-Bus) to one side of eight right row switch groups (RR1-8), representative switch group RR8 being shown in Figure 25C. Each right row switch group also receives a select right row signal (such as SRR8) from PA2 that opens or closes the switches. The other side of each right row switch group is bussed to the B side pads of die 8, 9, 24, 25, 40, 41, 56, and 57.

Referencing also Figure 25E, probe test pads in PA3 are bussed (via C-Bus) to one side of eight bottom column switch groups (BC1-8), representative switch group BC1 being shown in Figure 25E. Each bottom column switch group also receives a select bottom column signal (such as SBC1) from PA3 that opens or closes the switches. The other side of each bottom column switch group is bussed to the C side pads of die 57, 58, 59, 60, 61, 62, 63, and 64.

Referencing also Figure 25B, probe test pads in PA4 are bussed (via D-Bus) to one side of eight left row switch groups (LR1-8), representative switch group LR1 being shown in Figure 25B. Each left row switch group also receives a select left row signal (such as SLR1) from PA4 that opens or closes the switches. The other side of each left row switch group is bussed to the D side pads of die 1, 16, 17, 32, 33, 48, 49, and 64.

PA1-4, the switch groups, and bussing to connect them can all be located in the unusable peripheral area (recall Figure 3A) of the wafer.

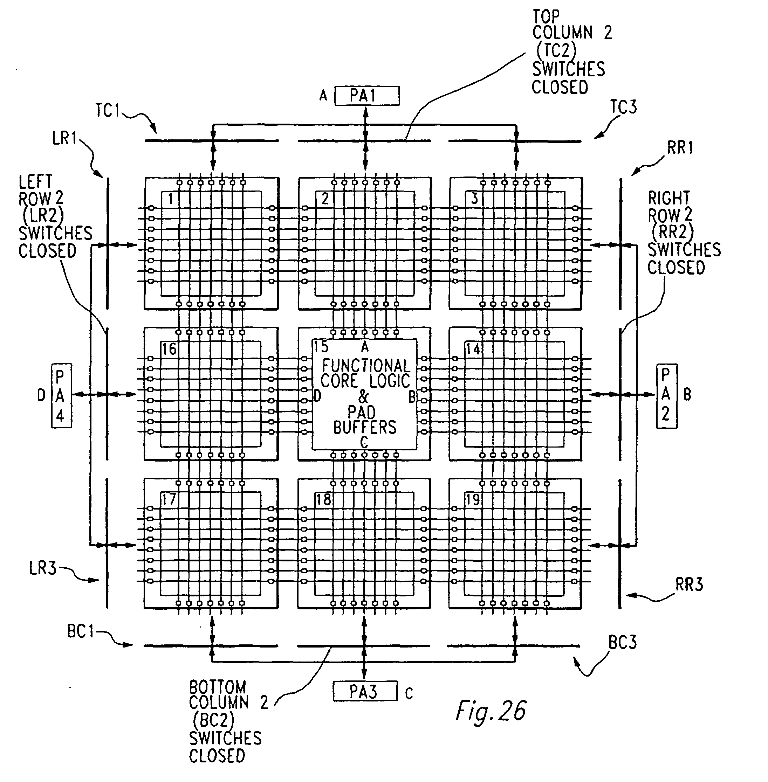

As shown in the detailed example of Figure 26, each die on the wafer, excluding the boundary die, such as die 1, 2, 3, 16, 17 etc. is connected at its top (A), right (B), bottom (C) and left (D) side pad sites to neighboring die pad sites by way of short busses that bridge across the scribe lanes between the die. Due to the regularity of the die and their positioning on the wafer, vertical pad bussing is provided between each neighboring die on sides A and C, and horizontal pad bussing is provided between each neighboring die on sides B and D. The pads of boundary die are similarly bussed to neighboring die pads, but only on at most three sides, since at least one of the boundary die sides will always be connected to a switch group.

Although not shown in Figure 25A, the wafer also comprises: (1) die having selectable functional and bypass modes as described in Figures 5-14, (2) WV and WG bussing as shown in Figures 15A-15B, and (3) fault tolerant die selectors as described in Figures 16 - 24.

Each switch group, when selected (switches closed), provides a low impedance, bidirectional signaling path. Also the bussing connections between PA1-4 and the switch groups (TC1-8, LR1-8, BC1-8, RR1-8), between the switch groups and the die sides (A, B, C, D), and between the die sides, provide a low impedance, bidirectional signaling path. As previously mentioned, the die's internal bypass pad-to-pad connections also provide low impedance, bidirectional signaling paths.

When testing is to be performed, a probe is positioned onto the wafer at the pad areas PA1-4. PA1-4 are large compared to the pad area of each die, and therefore the mechanical requirements of the probe design are simpler and less costly than conventional probes which are elegantly designed for contacting tiny die pads. For a die to be electronically selected for testing, the probe needs to be positioned onto the wafer only once, which reduces test time when compared to conventional multiple probing of a wafer. This test time reduction can significantly decrease the cost of wafer testing, which in turn decreases the cost of the die and packaged IC. Also, since the probe does not contact any die pads, no damage to die pads occurs during the wafer probe and die test procedure. Furthermore, the relatively large probe target area provided by PA1-4 lends itself well to computer controlled and automated test probing processes.

After the probe contacts the wafer at PA1-4, power is applied to the wafer to power up the die and die selectors. The tester can quickly detect a high current situation and remove power from the wafer as necessary. Wafer processing faults could cause shorts between WG and WV bussing or a die or die selector could have a V and G short. If the wafer fails the high current test at power up, die testing can still be done by conventional die probing techniques.

If the wafer exhibits normal current flow at power up, the die selectors can be tested as previously described with regard to Figures 16-24. If the die selectors fail in all fault tolerant modes, the wafer can still be tested conventionally. If the die selectors pass, the row and column bussing paths can be tested. To test row 1 and column 1 (Figures 25 and 26), the LR1, RR1, TC1 and BC1 switch groups are closed and, with all die in bypass mode, an external tester (such as in Figure 4) passes signals between PA4 and PA2 to test row 1 bussing and between PA1 and PA3 to test column 1 bussing. This step tests, (1) the PA1-4 to switch group bussing, (2) the switch group closures, (3) the switch group to boundary die bussing, (4) the die bypass mode, and (5) the die-to-die pad bussing. This step is repeated on all rows and columns. If a row or column fails, die associated with that row and column can be tested conventionally. After testing row and column connectivity, the die can be tested.

The die test starts by outputting a first pulse to S1 (could be S2, or S3 or S4 if die selector 201 is used) from PA4 to cause the upper left die selector to switch die 1 from bypass to functional mode, and then closing switch groups LR1, TC1, RR1 and BC1, and then testing die 1 using the external tester which is connected to die 1 via PA1-4, the closed switch groups and the row 1 and column 1 bussing paths. This test sequence is repeated on all die on the wafer. Figure 26 illustrates in detail the testing of die 15 via the row 2 and column 2 bussing paths. Different types of testing can be performed on a selected die. A first test is a DC test where the objective is to verify the I/O parametrics and the logical correctness of the die. A second test is a functional test wherein the die is functionally tested at its intended operating speed. Some high reliability applications require an environmental (or burn in) test where the die is tested in chambers where temperature, humidity, and vibration can be cycled during testing. Die that pass DC testing may fail functional and environmental testing, so at wafer level it is important to test die in DC, functional, and perhaps environmental test mode to prevent bad die from being packaged into IC form or assembled on MCMs.

To perform die testing, it is important to provide relatively high performance bussing paths, i.e. all the wafer routed bussing, the die bypass mode pad-to-pad connectivity bussing, and the switch group switches are preferably designed for low impedance and bidirectional signaling. In the die 15 test example of Figure 26, the D and A sides of die 15 receive test signaling from PA4 and PA1 through only bypassed die 16 and 2 respectively, whereas test signaling at sides B and C of die 15 must traverse more than one bypassed die (see Figure 25A) before arriving from PA2 and PA3, respectively. The die bypass signaling delay and die-to-die bussing delays can easily be modeled in tester software so that the tester can compensate for the delays through row and column bussing paths that traverse different numbers of die in bypass mode. In this way, test signaling between the tester and target die under test will occur correctly, independent of the number of bypassed die that exists in the row and column bussing paths connected to the A, B, C, and D sides of the die under test.

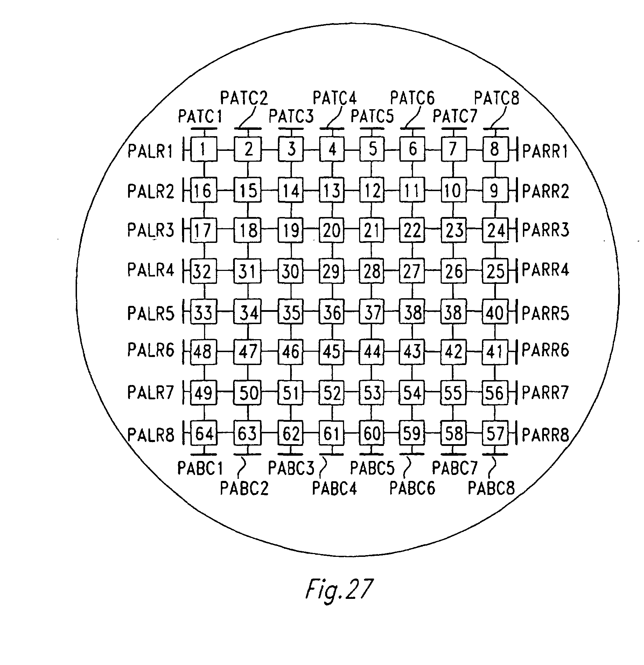

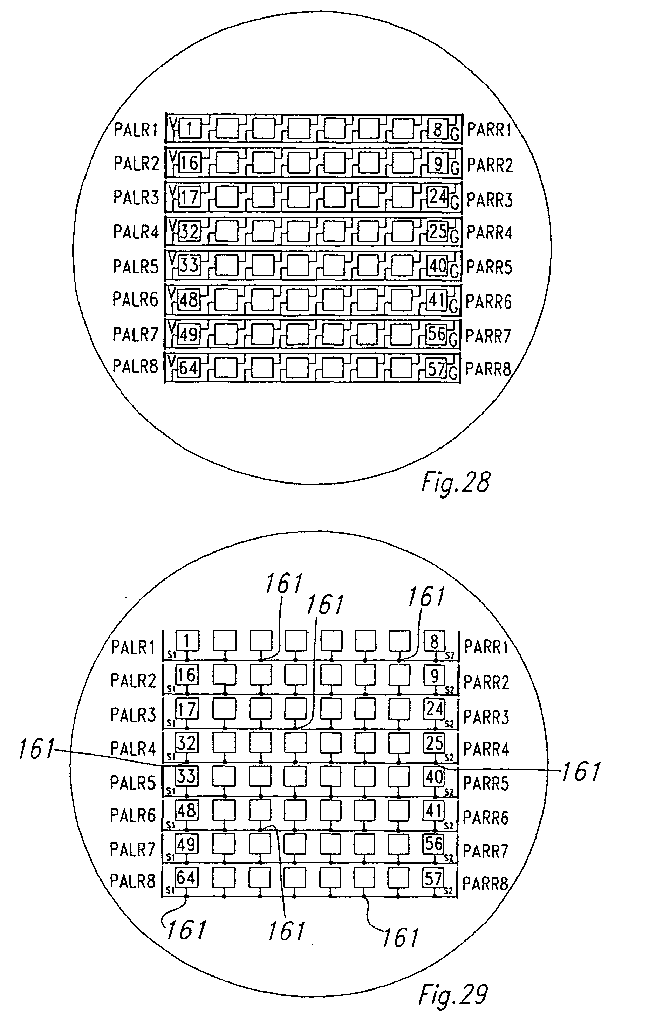

In exemplary Figure 27, a wafer bussing structure is shown where each row and column has its own pair of probe areas. For example probe area left row 1 (PALR1) and probe area right row 1 (PARR1) serve as the row 1 probe areas, and probe area top column 1 (PATC1) and probe area bottom column 1 (PABC1) serve as the column 1 probe areas. The die-to-die bussing is the same as described previously relative to Figures 25-26. Also the probe areas can exist in the unused peripheral area of the wafer. Optionally, the probe areas could be eliminated altogether and the pad sites at the A, B, C and D sides of the top, right, bottom, and left boundary die could be probed if desired. Figure 28 illustrates an example of how each row can be supplied, via its left and right probe areas PALRn and PARRn, with a unique V and G connection. Figure 29 illustrates how each row can be supplied, via its left and right probe areas PALRn and PARRn, with a unique die selector signaling connection. The power and die selector connections could also be arranged column-wise so that PATCn and PABCn would provide each column with unique power supply and die selection.

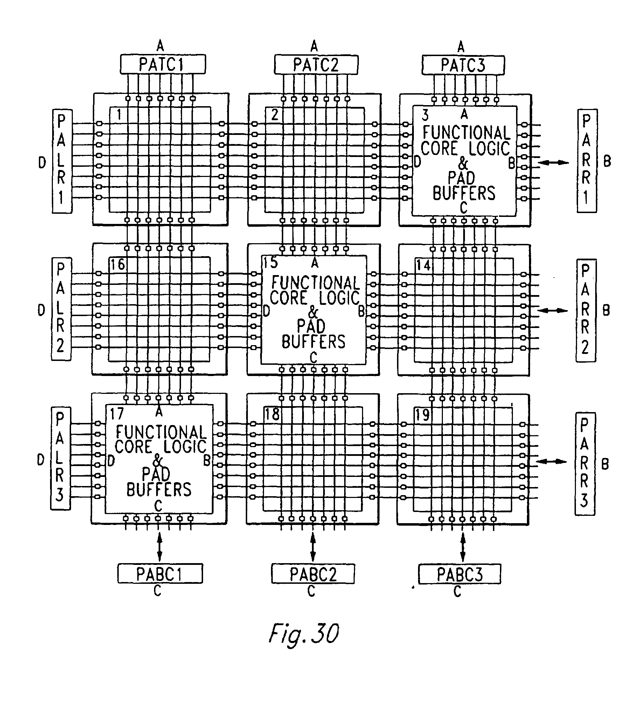

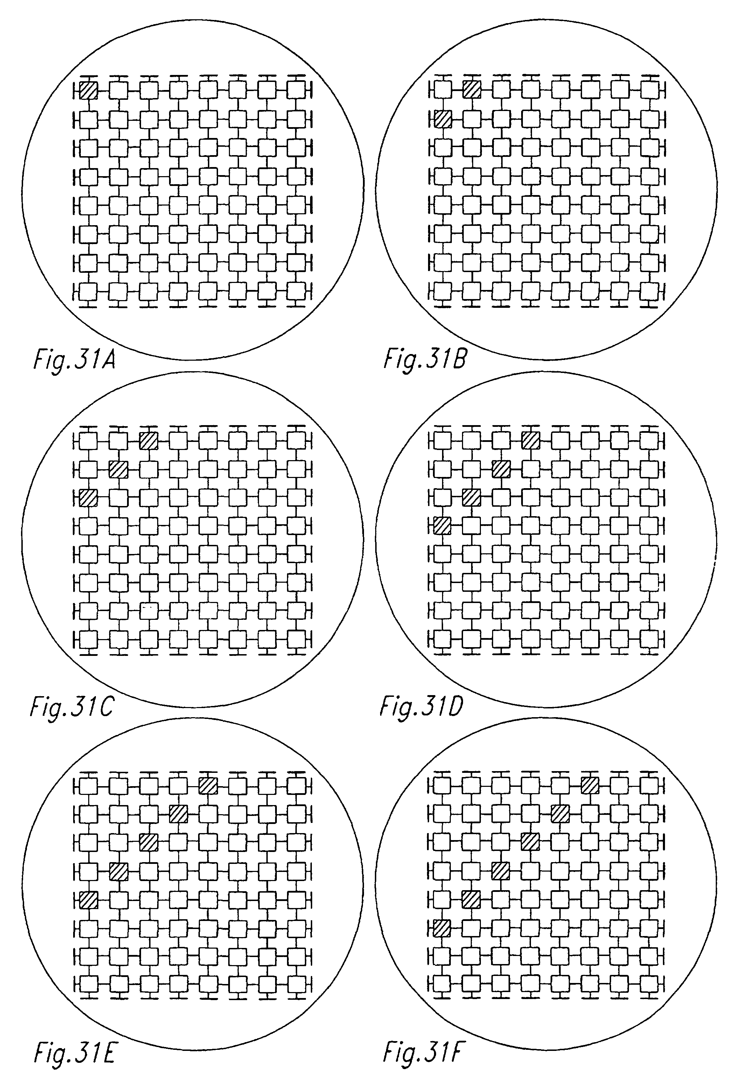

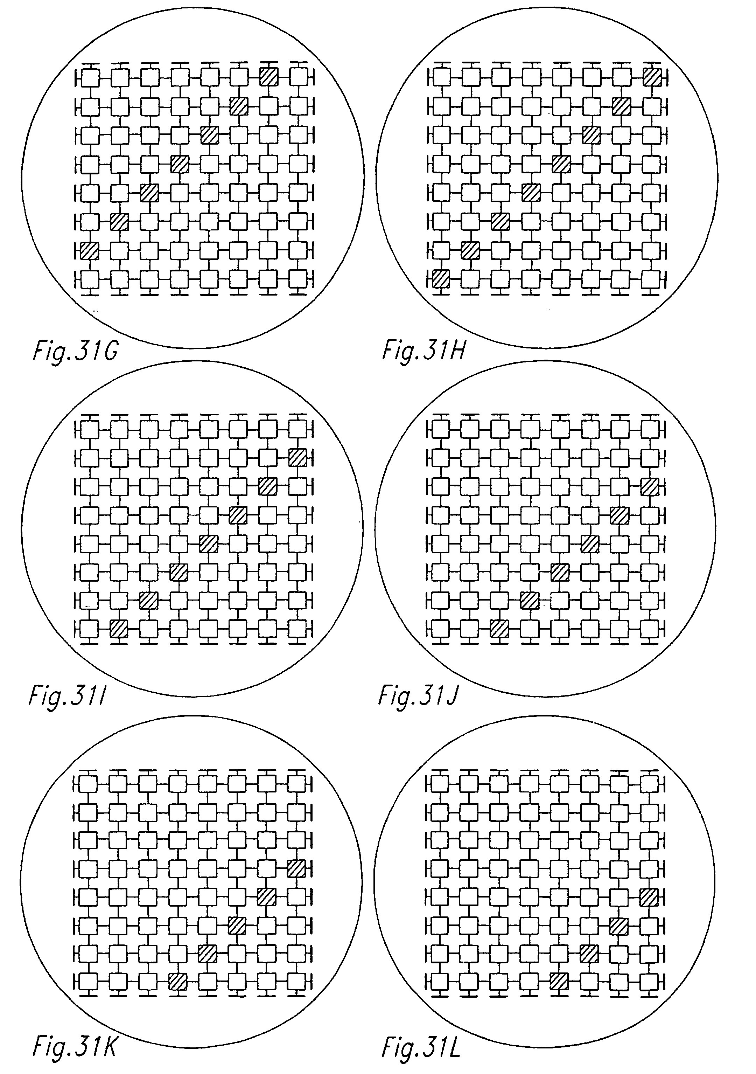

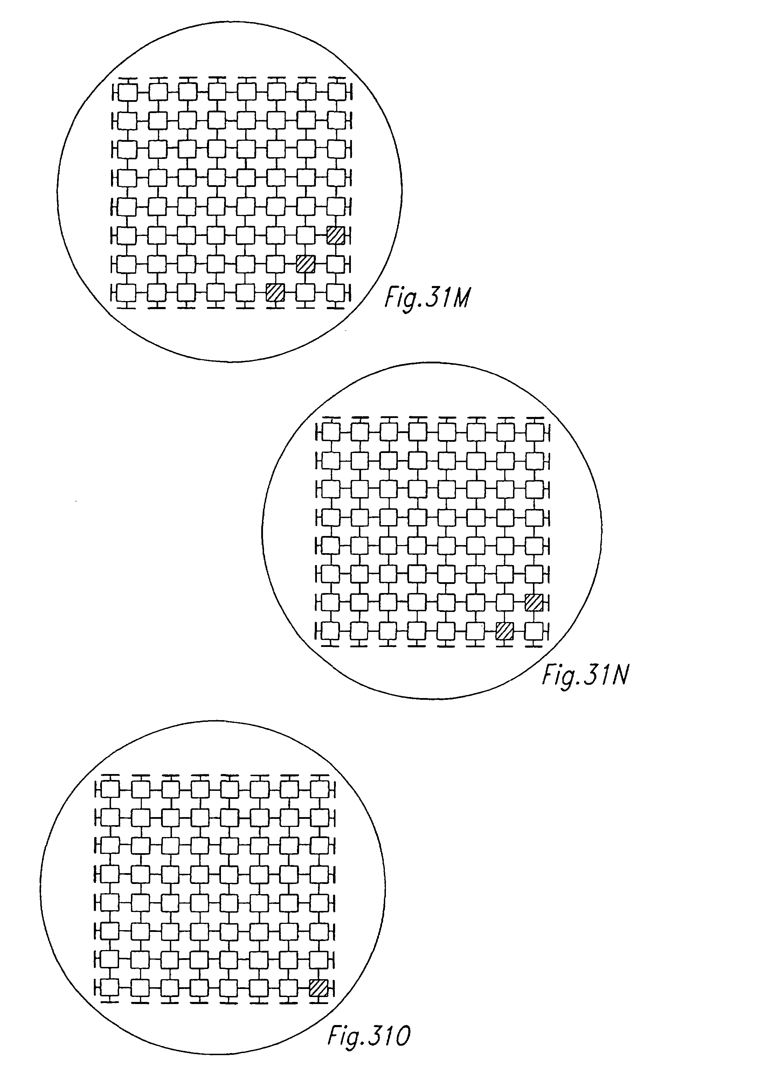

Exemplary Figure 30 illustrates in detail how diagonally positioned die 17, 15, and 3 are tested in parallel. If a group of diagonally positioned die are placed in functional mode (via each row's independently operated die selectors of Figure 29) while all other die are in bypass mode, then further test time reduction can be achieved by parallel (i.e. simultaneous) testing of the group of diagonally positioned die via the dedicated row and column bussing paths and probe areas shown in Figure 30. Figures 31A through 310 illustrate the parallel die testing approach as it proceeds across all groups of diagonally positioned die on the wafer. These steps of parallel die testing are listed below, using the die numbering of Figure 27.
Step 1 - Select and Test die 1 (Figure 31A).
Step 2 - Select and Test die 16 and 2 (Figure 31B).
Step 3 - Select and Test die 17, 15, and 3 (Figure 31C).
Step 4 - Select and Test die 32, 18, 14, and 4 (Figure 3D).
Step 5 - Select and Test die 33, 31, 19, 13, and 5 (Figure 31E).
Step 6 - Select and Test die 48, 34, 30, 20, 12, and 6 (Figure 31F).
Step 7 - Select and Test die 49, 47, 35, 29, 21, 11, and 7 (Figure 31G)
Step 8 - Select and Test die 64, 50, 46, 36, 28, 22, 10, and 8 (Figure 31H)
Step 9 - Select and Test die 63, 51, 45, 37, 27, 23, and 9 (Figure 31I)
Step 10 - Select and Test die 62, 52, 44, 38, 26, and 24 (Figure 31J).
Step 11 - Select and Test die 61, 53, 43, 39, and 25 (Figure 31K)
Step 12 - Select and Test die 60, 54, 42, and 40 (Figure 31L).
Step 13 - Select and Test die 59, 55, and 41 (Figure 31M).
Step 14 - Select and Test die 58 and 56 (Figure 31N).
Step 15 - Select and Test die 57 (Figure 310).

The above-described parallel testing of die on wafer can reduce wafer test time as compared to individual, sequential testing of die on wafer. It is also applicable to IDDQ testing of each die on the wafer. IDDQ testing is the monitoring of current to an IC/die during the application of test patterns. A higher than expected current at a particular test pattern may indicate a defect. The WV and WG bussing arrangement of Figure 15A is adequate when performing IDDQ testing in the one-die-at-a-time arrangement of Figures 25-26, because any unexpected current on WV and/or WG can be attributed to the one die that is in functional mode. As to the parallel die testing arrangement of Figures 30-31, row-specific V and G bussing of the type shown in Figure 28 permits unexpected V and G current to be attributed to the correct die of the diagonal grouping being tested. If this capability is not desired in the test arrangement of Figures 30-31, then the WV and WG bussing of the type shown in Figure 15A can be used in Figures 30-31. For example, an additional probe access area could be provided for power supply bussing, in which case PALRn and PARRn need not provide power.

As mentioned above, this permits the tester probe design to be greatly simplified relative to prior art designs, resulting in less expensive testers. Thus, even the IC vendor's customers can afford to maintain their own wafer tester. This permits the vendor to sell complete wafers (rather than singulated die) to customers, who can then repeat the vendor's wafer test and verify the results, and then advantageously singulate the die for themselves. The vendor is thus relieved of the risk of damaging die during singulation, while the customers can advantageously obtain unpackaged die (on wafer), verify that the die have not been damaged in transit from the vendor, and.then singulate the die themselves.

## Claims

1. An integrated circuit, comprising:
functional circuitry for performing normal operating functions of the integrated circuit, said integrated circuitry including first and second nodes which are electrically distinct from each other; and
first (D-1) and second (B-1) bond pads selectively connectable to and disconnectable from said first and second nodes, respectively, said first (D-1) and second (B-1) bond pads also selectively connectable to and disconnectable from each other;
a first lead connecting the first bond pad (D-1) to the first node; and
a second lead, the second lead connecting the second bond pad (B-1) to the second node;
the integrated circuit further including first switching circuitry (71) for selectively disconnecting the first bond pad (D-1) from the first node and second switching circuitry (A,3SO) for selectively disconnecting the second bond pad (B-1) from the second node **characterized by** a selectable connection path (73,75,77,79) for selectively and directly connecting together the first bond pad (D-1) and the second bond (B-1) pad for passage of electrical signals from the first bond pad (D-1) to the second bond pad (B-1) and from the second bond pad (B-1) to the first bond pad (D-1) when the first and second nodes are disconnected from the first and second bond pads.

2. The integrated circuit of claim 1, in which the functional circuitry includes an input buffer and an output buffer and the first node is the input to the input buffer and the second node is the output of the output buffer.

3. The integrated circuit of claim 1, in which the functional circuitry includes an input buffer and including a state holding circuit (ISH) between the first switching circuitry (71) and the input of the input buffer.

4. The integrated circuit of claim 1, in which the functional circuitry includes two input buffers and the first node is an input to one input buffer and the second node is an input to the other input buffer.

5. The integrated circuit of claim 1, in which the functional circuitry includes two output buffers and the first node is an output of one output buffer and the second node is an output of the other output buffer.

## Patentansprüche

1. Integrierte Schaltung, welche aufweist:
eine funktionelle Schaltungsanordnung zum Ausführen normaler Betriebsfunktionen der integrierten Schaltung, wobei die integrierte Schaltungsanordnung einen ersten und einen zweiten Knoten aufweist, die elektrisch voneinander abgesetzt sind, und
eine erste Bondkontaktstelle (D-1) und eine zweite Bondkontaktstelle (B-1), die selektiv mit dem ersten und dem zweiten Knoten verbindbar bzw. davon trennbar sind, wobei die erste Bondkontaktstelle (D-1) und die zweite Bondkontaktstelle (B-1) auch selektiv miteinander verbindbar und selektiv voneinander trennbar sind,
eine erste Leitung, die die erste Bondkontaktstelle (D-1) mit dem ersten Knoten verbindet, und
eine zweite Leitung, die die zweite Bondkontaktstelle (B-1) mit dem zweiten Knoten verbindet,
wobei die integrierte Schaltung weiter eine erste Schalteranordnung (71) zum selektiven Trennen der ersten Bondkontaktstelle (D-1) vom ersten Knoten und eine zweite Schalteranordnung (A, 3SO) zum selektiven Trennen der zweiten Bondkontaktstelle (B-1) vom zweiten Knoten aufweist,
**gekennzeichnet durch**:
einen auswählbaren Verbindungsweg (73, 75, 77, 79) zum selektiven und direkten Zusammenschalten der ersten Bondkontaktstelle (D-1) und der zweiten Bondkontaktstelle (B-1) zum Leiten elektrischer Signale von der ersten Bondkontaktstelle (D-1) zur zweiten Bondkontaktstelle (B-1) und von der zweiten Bondkontaktstelle (B-1) zur ersten Bondkontaktstelle (D-1), wenn der erste und der zweite Knoten von der ersten und der zweiten Bondkontaktstelle getrennt sind.

2. Integrierte Schaltung nach Anspruch 1, wobei die funktionelle Schaltungsanordnung einen Eingabepuffer und einen Ausgabepuffer aufweist und der erste Knoten der Eingang in den Eingabepuffer ist und der zweite Knoten der Ausgang des Ausgabepuffers ist.

3. Integrierte Schaltung nach Anspruch 1, wobei die funktionelle Schaltungsanordnung einen Eingabepuffer und eine Zustandshalteschaltung (ISH) zwischen der ersten Schalteranordnung (71) und dem Eingang des Eingabepuffers aufweist.

4. Integrierte Schaltung nach Anspruch 1, wobei die funktionelle Schaltungsanordnung zwei Eingabepuffer aufweist und der erste Knoten ein Eingang für einen Eingabepuffer ist und der zweite Knoten ein Eingang für den anderen Eingabepuffer ist.

5. Integrierte Schaltung nach Anspruch 1, wobei die funktionelle Schaltungsanordnung zwei Ausgabepuffer aufweist und der erste Knoten ein Ausgang eines Ausgabepuffers ist und der zweite Knoten ein Ausgang des anderen Ausgabepuffers ist.

## Revendications

1. Circuit intégré comportant;
un circuit fonctionnel pour exécuter des fonctions de fonctionnement normal du circuit intégré, ledit circuit intégré comprenant des premier et second noeuds qui sont électriquement distants l'un de l'autre; et
des premiers plots de connexion (D-1) et des seconds plots de connexion (B-1) pouvant être connectés sélectivement auxdits premier et second noeuds et en être déconnectés, respectivement, lesdits premiers plots de connexion (D-1) et lesdits seconds plots de connexion (B-1) pouvant également être sélectivement connectés l'un à l'autre et être déconnectés l'un de l'autre;
un premier fil connectant le premier plot de connexion (D-1) au premier noeud; et
un second fil connectant le second plot de connexion (B-1) au second noeud;
le circuit intégré comprenant en outre un premier circuit de commutation (71) pour déconnecter sélectivement le premier plot de connexion (D-1) du premier noeud, et un second circuit de commutation (A, 3SO) pour déconnecter sélectivement le second plot de connexion (B-1) du second noeud;
**caractérisé par**
un trajet de connexion (73,75,77,79) pouvant être sélectionné pour connecter sélectivement et directement conjointement le premier plot de connexion (D-1) et le second plot de connexion (B-1) pour le passage de signaux électriques depuis le premier plot de connexion (D-1) vers le second plot de connexion (B-1) et depuis le second plot de connexion (B-1) au premier plot de connexion (D-1) lorsque les premier et second noeuds sont déconnectés des premier et second plots de connexion.

2. Circuit intégré selon la revendication 1, dans lequel le circuit fonctionnel inclut un tampon d'entrée et un tampon de sortie et le premier noeud constitue l'entrée du tampon d'entrée et le second noeud constitue la sortie du tampon de sortie.

3. Circuit intégré selon la revendication 1, dans lequel le circuit fonctionnel inclut un tampon d'entrée et inclut un circuit de maintien d'état (ISH) entre le premier circuit de commutation (71) et l'entrée du tampon d'entrée.

4. Circuit intégré selon la revendication 1, dans lequel le circuit fonctionnel inclut deux tampons d'entrée et le premier noeud constitue une entrée pour un tampon d'entrée et le second noeud constitue une entrée pour l'autre tampon d'entrée.

5. Circuit intégré selon la revendication 1, dans lequel le circuit fonctionnel inclut deux tampons de sortie et le premier noeud constitue une sortie d'un tampon de sortie et le second noeud constitue une sortie de l'autre tampon de sortie.
